# EUROPÄISCHE PATENTANMELDUNG

(11) **EP 1 211 441 A2**
(43) Veröffentlichungstag der Anmeldung: **05.06.2002**
(21) Anmeldenummer: 01122177.7
(22) Anmeldetag: 15.09.2001
(51) Int. Cl.: F16H 59/12

(54) **Drucktastenwähleinrichtung mit LED-Anzeige**

(30) Priorität: 04.12.2000 DE 20020621 U
(71) Anmelder: Voith Turbo GmbH & Co. KG, 89522 Heidenheim (DE)
(72) Erfinder: Bürk, Richard, 88454 Hochdorf (DE); Dietzel, Bernd, 89428 Syrgenstein (DE)
(74) Vertreter: Dr. Weitzel & Partner

(57) **Zusammenfassung**

Die Erfindung betrifft eine Vorwahleinrichtung zur Vorgabe eines Fahrerwunsches zur Einstellung oder Änderung eines Fahrzustandes durch Ansteuerung der Getriebebaueinheit in Antriebssträngen eines Fahrzeuges;
- mit jeweils einem, einem bestimmten Fahrzustand zugeordneten Bedien- oder Betätigungselement;
- mit einer, jedem Bedien- oder Betätigungselement zugeordneten optischen Anzeigeneinrichtung (6.1).
- die optische Anzeigeneinrichtung umfaßt jeweils mindestens eine Lumineszenzdiode (6.1) mit einem Kopfteil (8) und einem Anschlußteil (9), welches stoffschlüssig an einer Leiterplatte (10) befestigt ist, die wenigstens mittelbar elektronisch mit dem Betätigungselement gekoppelt ist;
- und einer auf der Leiterplatte befestigbaren Halteeinrichtung (13) zur Fixierung der Lage der Lumineszenzdiode gegenüber der Leiterplatte.

## Beschreibung

Die Erfindung betrifft eine Vorwahleinrichtung zur Vorgabe eines Fahrerwunsches zur Einstellung eines bestimmten Fahrzustandes durch Ansteuerung des Getriebes, insbesondere Tastenschalter, im einzelnen mit den Merkmalen aus dem Oberbegriff des Anspruchs 1.

Vorwahleinrichtungen für die Vorgabe eines Fahrerwunsches zur Einstellung eines bestimmten Fahrzustandes, welcher durch entsprechende Ansteuerung einer Getriebebaueinheit, insbesondere der Schaltelemente und/oder der hydrodynamischen Leistungsübertragungs- oder Wandlungseinrichtungen einer Getriebebaueinheit eingestellt werden kann, sind in verschiedenen Ausführungen bekannt. Für den Einsatz in Nutzfahrzeugen, insbesondere Bussen, finden vor allem Tastschaltereinrichtungen Verwendung. Diese weisen eine bestimmte Anzahl von Bedien- oder Betätigungselementen auf, mittels welchen der entsprechend gewünschte Fahrzustand vorgewählt werden kann. Dabei werden jedoch wenigstens die folgenden drei Fahrzustände unterschieden:
a) "Leerlauf", welcher einer, mit dem Betätigungselement einstellbaren Neutralstellung entspricht
b) "Rückwärtsfahrt"
c) "Vorwärtsfahrt", wobei unter Ausnutzung einer bestimmten Anzahl von theoretisch möglichen Gangstufen des automatischen Getriebes ein bestimmter vordefinierbarer Übersetzungsbereich aus einem theoretisch möglichen Gesamtübersetzungsbereich überstrichen werden kann.

In der Regel sind dazu den einzelnen Betätigungselementen Erfassungseinrichtungen für die Funktionsstellungen zugeordnet, wobei aus den mittels dieser Einrichtungen erfaßten Größen und generierten Signalen und den entsprechenden Verknüpfungen der Signalergebnisse in einer Steuereinrichtung, vorzugsweise Getriebesteuerung, die entsprechenden Funktionszustände eindeutig abgeleitet werden. Zur Erkennung der Betätigung einer Taste, das heißt der aktiven Taste und zur Fehlerausgabe sind den einzelnen Betätigungselementen optische Erkennungsmittel in Form von Glühlampen zugeordnet. Diese sind dabei in der Regel unter lichtdurchlässigen Tastenkappen angeordnet. Zur Realisierung der Funktionsweise ist dazu ein Halter für jede einzelne Glühlampe erforderlich, welcher in Form einer Fassung mit elektrischen Kontakten ausgeführt ist und mit einer den einzelnen Betätigungselementen elektrisch gekoppelten Leiterplatte verbunden ist. Dabei ist es erforderlich, die Fassung einzulöten und des weiteren in einem weiteren Verfahrensschritt die Glühlampen in die entsprechenden Fassungen einzustecken. Glühlampen sind jedoch verhältnismäßig teuer und weisen eine geringe Lebensdauer auf. Des weiteren sind Glühlampen erschütterungsempfindlich.

Der Erfindung liegt daher die Aufgabe zugrunde, eine Vorwahleinrichtung zur Vorgabe eines Fahrerwunsches zur Einstellung eines bestimmten Fahrzustandes durch Ansteuerung der Getriebebaueinheit derart weiterzuentwickeln, daß die genannten Nachteile vermieden werden, insbesondere eine relativ preisgünstige, gegenüber Erschütterungen unempfindliche sowie hinsichtlich der Fertigung und Montage einfache und wenig störempfindliche Lösung zur Erkennung der aktiv betätigten Taste zu schaffen.

Die erfindungsgemäße Lösung ist durch die Merkmale des Anspruchs 1 charakterisiert. Vorteilhafte Ausgestaltungen sind in den Unteransprüchen beschrieben.

Die Vorwahleinrichtung zur Vorgabe eines Fahrerwunsches zur Einstellung beziehungsweise Änderung eines Fahrzustandes durch Ansteuerung der Betriebsweise einer Getriebebaueinheit in einem Antriebsstrang von Fahrzeugen umfaßt jeweils ein, einem bestimmten Fahrzustand zugeordnetes Betätigungs- oder Bedienelement. Jedem Bedienelement ist eine optische Anzeigeneinrichtung zugeordnet, welche bei Betätigung den Betätigungszustand zu erkennen gibt. Erfindungsgemäß umfaßt die optische Anzeigeneinrichtung eine Lumineszenzdiode, umfassend einen Kopfteil und einen Anschlußteil, der an einer, elektrisch mit dem einzelnen Bedienelement koppelbaren Leiterplatte befestigt ist. Jeder Lumineszenzdiode ist eine Halteeinrichtung zugeordnet, welche ebenfalls in der Leiterplatte befestigbar ist und die die Fixierung der Lage der Diode gegenüber der Leiterplatte vornimmt.

Die erfindungsgemäße Lösung ist durch eine stark vereinfachtere Konstruktion der Halteeinrichtung charakterisiert, da diese keine elektrischen Kontakte trägt. Des weiteren fällt der manuelle Fertigungsschritt des Einsteckens des Leuchtmittels in die Fassung - wie bei der Glühlampe üblich - weg, da die Lumineszenzdiode, insbesondere der Anschlußteil direkt mit der Leiterplatte verlötet wird. Zudem zeichnet sich eine Lumineszenzdiode durch einen geringeren Preis sowie eine längere Lebensdauer und die Unempfindlichkeit gegenüber Erschütterungen aus, da die Diode direkt mit der Leiterplatte verlötet wird und somit kein zusätzliches Zwischenelement in Form einer Fassung mehr erforderlich ist. Der Stromverbrauch einer derartigen Diode ist ebenfalls sehr gering.

Die elektrische Kopplung zwischen der Lumineszenzdiode und der Leiterplatte erfolgt derart, daß bei Betätigung des der Lumineszenzdiode zugeordneten Bedien- oder Betätigungselementes am Anschlußteil eine in Durchlaßrichtung gepolte Spannung anliegt, welche zur Emission von Strahlung führt.

Die Halteeinrichtung selbst ist aus Fertigungsgründen vorzugsweise lösbar mit der Leiterplatte verbindbar.

Die Halteeinrichtung ist im einfachsten Fall derart ausgeführt, daß diese lediglich eine jeweils äußere Begrenzung für die Bewegbarkeit des Kopf- und/oder Anschlußteiles der Lumineszenzdiode bildet. Bezüglich der Lagefixierung bestehen eine Mehrzahl von Möglichkeiten:
a) die Halteeinrichtung fixiert das Anschlußteil hinsichtlich seiner Lage und dementsprechend das über die Halteeinrichtung hinausstehende Kopfteil
b) die Halteeinrichtung stützt aktiv nur das Kopfteil, in dem ein Anschlag oder eine formschlüssige Verbindung zwischen Halteteil und Kopfteil realisiert wird, während das Anschlußteil hinsichtlich seiner Lage durch das Kopfteil und die Verlötung mit der Leiterplatte fixiert ist
c) die Halteeinrichtung stützt das Kopfteil und aktiv das Anschlußteil,
wobei einem oder beiden Elementen - Kopf- und/oder Anschlußteil-Mittel zur formschlüssigen Verbindung mit der Halteeinrichtung zugeordnet sind.

Zur Gewährleistung einer sicheren Funktionsweise gelangt vorzugsweise die Variante c) zum Einsatz. Dabei erfolgt die Realisierung des Formschlusses in der Regel durch eine Art Clip- oder Schnappverbindung, mittels welcher das Anschlußteil und/oder das Kopfteil hinsichtlich seiner Lage in einer Führung fixiert wird.

Die Vorwahleinrichtung ist im einfachsten Fall als Tastschaltereinrichtung ausgeführt. In diesem Fall bilden einzelne Tasten die Bedienbeziehungsweise Betätigungselemente, wobei die optische Anzeigeeinrichtung direkt in der Betätigungseinrichtung integriert ist. Diese Lösung zeichnet sich durch einen hohen Grad an Kompaktheit aus.

Eine weitere Möglichkeit besteht darin, die Vorwahleinrichtung in Form von Kipp- oder Drehschaltern auszuführen, wobei hier die optischen Anzeigeneinrichtungen in der Regel mit einem bestimmten Abstand von dem entsprechenden Betätigungselement angeordnet sind und somit eine zumindest elektrische Kopplung zwischen dem Betätigungselement und der optischen Anzeigeeinrichtung erforderlich ist.

Die erfindungsgemäße Lösung wird nachfolgend anhand von Figuren erläutert. Darin ist im einzelnen folgendes dargestellt:
- Figur 1: verdeutlicht in schematisch stark vereinfachter Darstellung eine Vorwahleinrichtung zur Vorgabe eines Fahrerwunsches zur Einstellung eines bestimmten Fahrzustandes in Form eines Tastenschalters, in dessen Betätigungselemente jeweils eine Lumineszenzdiode als optische Anzeigeneinrichtung integriert ist;
- Figur 2: verdeutlicht die Ausführung einer Halteeinrichtung mit Lumineszenzdiode zum Einsatz in einer erfindungsgemäß gestalteten Vorwahleinrichtung.

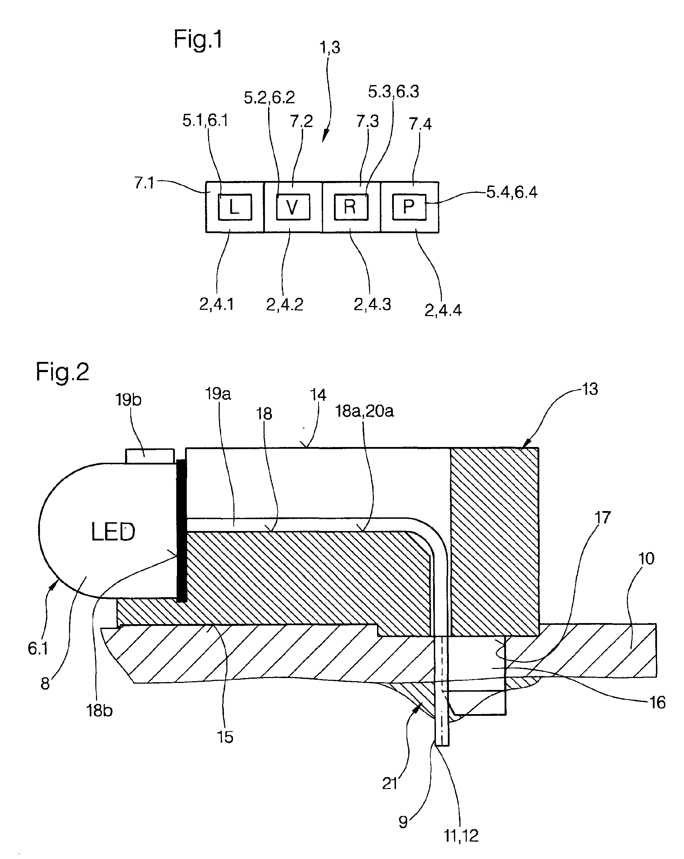

Figur 1 verdeutlicht in schematisch vereinfachter Darstellung eine Vorwahleinrichtung 1 zur Vorgabe eines Fahrerwunsches zur Einstellung oder Änderung eines Fahrzustandes durch Ansteuerung der Getriebebaueinheit, wobei mindestens die nachfolgend genannten Fahrzustände unterschieden werden:
a) "Leerlauf"
b) "Rückwärtsfahrt"
c) "Vorwärtsfahrt",
wobei unter Ausnutzung einer bestimmten Anzahl von theoretisch möglichen Gangstufen des automatischen Getriebes oder automatisierten Getriebes ein bestimmter vordefinierbarer Übersetzungsbereich aus einem theoretisch möglichen Gesamtübersetzungsbereich überstrichen werden kann.

Die Vorwahleinrichtung 1 umfaßt ein, jedem Fahrzustand zuordenbares Bedien- oder Betätigungselement 2, im dargestellten Fall bei Ausführung der Vorwahleinrichtung als Tastschalteinrichtung 3 in Form von Tasten 4.1 bis 4.n. Diese sind mit einer elektronischen Steuereinrichtung zur Ansteuerung der Getriebebaueinheit koppelbar. Den einzelnen Bedien- oder Betätigungselementen 2 ist dabei eine optische Anzeigeeinrichtung 5.1 bis 5.n zugeordnet, welche-mindestens jeweils eine Lumineszenzdiode 6.1 bis 6.n umfassen. Die Lumineszenzdioden sind dabei im Betätigungselement 2 integriert, vorzugsweise unterhalb einer Plastikhaube 7.1 bis 7.n angeordnet, welche zumindest im gewissen Grade lichtdurchlässig ist.

Jede Lumineszenzdiode 6.1 bis 6.n umfaßt, beispielhaft 6.1 wie in Figur 2 dargestellt, einen Kopfteil 8 und einen Anschlußteil 9. Der Anschlußteil 9 ist dabei elektronisch mit dem Betätigungselement 2, beispielsweise über eine Leiterplatte 10, gekoppelt. Die elektrische Kopplung erfolgt dabei derart, daß bei Betätigung eines Betätigungselementes 2 der Anschlußteil 9, welcher eine Kathode 11 und eine Anode 12 umfaßt, mit einer Spannung beaufschlagt wird, welche die Diode in Durchlaßrichtung betreibt. Der Kopfteil 8 umfaßt dabei einen hier im einzelnen nicht dargestellten Chip, eine Reflektorwanne sowie einen Aᵤ-Draht, welcher den an der Kathode 11 angeordneten Chip und die Reflektorwanne mit der Anode verbindet. Chip, Reflektorwanne und Aᵤ -Draht sind dabei mit einem Kunststoff überzogen, welcher die äußere Begrenzung des Kopfteils 8 darstellt.

Figur 2 verdeutlicht dabei anhand einer Seitenansicht auf die Leiterplatte 10 beispielhaft eine Fixierung der Lumineszenzdiode 6.1 gegenüber der Leiterplatte 10 über eine Halteeinrichtung 13, welche der Lagefixierung der Lumineszenzdiode 6 dient. Die Halteeinrichtung 13 ist dabei frei von elektrischen Kontakten. Im einfachsten Fall bildet diese Halteeinrichtung 13 jeweils mit ihren inneren Abmessungen einen Anschlag für die Bewegbarkeit der Lumineszenzdiode 6.1, insbesondere der einzelnen Elemente - Anschlußteil 9 oder Kopfteil 8. Zu diesem Zweck ist die Halteeinrichtung 13 in Einbaulage betrachtet nach oben, das heißt an der von der Leiterplatte 10 wegweisenden Stirnseite 14 oder einer senkrecht zur Leiterplatte 10 stehenden Stirnseite offen ausgeführt, das heißt weist mindestens eine Ausnehmung auf, die zur Aufnahme von Teilen der Lumineszenzdiode 6.1 in der Halteeinrichtung 13 dient. Die Halteeinrichtung 13 selbst ist dabei vorzugsweise lösbar, beispielsweise über eine formschlüssige Verbindung mit der Leiterplatte 10 verbunden. Im dargestellten Fall weist dazu die Halteeinrichtung 13 an ihrer zur Leiterplatte hin gerichteten Stirnseite 15 mindestens einen Vorsprung 16 auf, der mit dazu komplementär ausgeführten Ausnehmungen, insbesondere Bohrungen 17 an der Leiterplatte in Wirkverbindung tritt. Dabei kann die Realisierung der Wirkverbindung beispielsweise auch durch eine Schnappverbindung verwirklicht werden, bei welcher der Formschluß durch entsprechende Führung des Vorsprunges 16 in der Ausnehmung 17 realisiert wird und nur durch zusätzliche Maßnahmen von außen wieder aufgehoben werden kann.

Bei der in der Figur 2 dargestellten besonders vorteilhaften Ausführung der Lagefixierung der Lumineszenzdiode 6.1 in der Halteeinrichtung 13 erfolgt sowohl die Abstützung des Kopfteiles 8 als auch des Anschlußteiles 9 in der Halteeinrichtung 13. Beide Teile werden dabei durch mindestens eine Innenwand oder einen Teilbereich dieser, hier mit 18 bezeichnet, geführt. Vorzugsweise ist dabei der Innenwandbereich 18a, welcher der Abstützung des Anschlußteiles 9 dient und der Innenwandbereich 18b, welcher der Abstützung des Kopfteiles 8 dient, jeweils mit Mitteln zur Realisierung einer formschlüssigen Verbindung, hier mit 19a und 19b bezeichnet, versehen. Dabei sind die Mittel zur formschlüssigen Verbindung 19a zur Abstützung und Lagefixierung des Kopfteiles 8 in Form eines formschlüssig am Kopfteil wirksam werdenden Clips ausgeführt, während das Anschlußteil 9, insbesondere die Kathode 11 und die Anode 12 wenigstens teilweise in entsprechenden Führungen 20 im Innenwandbereich 18a eingelegt werden können, wobei die Führungen ebenfalls mit Clips versehen werden können. Die Fixierung des Anschlußteils 9 an der Leiterplatte 10 erfolgt über Stoffschluß, vorzugsweise eine Lötverbindung 21.

### Bezugszeichenliste

- 1: Vorwahleinrichtung
- 2: Bedien- oder Betätigungselement
- 3: Tastschaltereinrichtung
- 4.1 - 4.n: Tasten
- 5.1 - 5.n: optische Anzeigeeinrichtung
- 6.1 - 6.n: LED
- 7.1 - 7.n: Plastikhaube
- 8: Kopfteil
- 9: Anschlußteil
- 10: Leiterplatte
- 11: Kathode
- 12: Anode
- 13: Halteeinrichtung
- 14: Stirnseite
- 15: zur Leitungsplatte ausgerichtete Stirnseite
- 16: Vorsprung
- 17: Ausnehmung
- 18: Innenwand
- 18a: Innenwandbereich
- 18b: Innenwandbereich
- 19a: Mittel zur formschlüssigen Verbindung
- 19b: Mittel zur formschlüssigen Verbindung
- 20a, 20b: Führungen
- 21: Lötverbindung

## Patentansprüche

1. Vorwahleinrichtung (1) zur Vorgabe eines Fahrerwunsches zur Einstellung oder Änderung eines Fahrzustandes durch Ansteuerung der Getriebebaueinheit in Antriebssträngen eines Fahrzeuges;
1.1 mit jeweils einem, einem bestimmten Fahrzustand zugeordneten Bedien- oder Betätigungselement (2.1 - 2.n);
1.2 mit einer, jedem Bedien- oder Betätigungselement (2.1 - 2.n) zugeordneten optischen Anzeigeneinrichtung (5.1 - 5.n); **gekennzeichnet durch** die folgenden Merkmale:
1.3 die optische Anzeigeneinrichtung (5.1 - 5.n) umfaßt jeweils mindestens eine Lumineszenzdiode (6.1 - 6.n) mit einem Kopfteil (8) und einem Anschlußteil (9), welches stoffschlüssig an einer Leiterplatte (10) befestigt ist, die wenigstens mittelbar elektronisch mit dem Betätigungselement (2.1 - 2.n) gekoppelt ist;
1.4 mit einer mindestens einer Lumineszenzdiode (6.1 - 6.n) zugeordneten und auf der Leiterplatte (10) befestigbaren Halteeinrichtung (13) zur Fixierung der Lage der Lumineszenzdiode (6.1 - 6.n) gegenüber der Leiterplatte (10).

2. Vorwahleinrichtung (1) nach Anspruch 1, **dadurch gekennzeichnet, daß** die Halteeinrichtung (13) lösbar mit der Leiterplatte (10) verbunden ist.

3. Vorwahleinrichtung (1) nach einem der Ansprüche 1 oder 2, **dadurch gekennzeichnet, daß** jeder Lumineszenzdiode (6.1 - 6.n) eine Halteeinrichtung (13) zugeordnet ist.

4. Vorwahleinrichtung (1) nach einem der Ansprüche 1 bis 3, **dadurch gekennzeichnet, daß** wenigstens Teilbereiche der Innenwände (18) der Halteeinrichtung (13) eine Führung für den Kopfteil (8) und/oder den Anschlußteil (9) der Lumineszenzdiode (6.1 - 6.n) beschreiben, wobei die Führungswände einen Anschlag bilden.

5. Vorwahleinrichtung (1) nach einem der Ansprüche 1 bis 4, **dadurch gekennzeichnet, daß** das Kopfteil (8) wenigstens teilweise direkt in der Halteeinrichtung (13) anliegt.

6. Vorwahleinrichtung (1) nach einem der Ansprüche 1 bis 5, **dadurch gekennzeichnet, daß** das Anschlußteil (9) wenigstens teilweise in der Halteeinrichtung (13) anliegt.

7. Vorwahleinrichtung (1) nach einem der Ansprüche 1 bis 6, **dadurch gekennzeichnet, daß** dem Kopfteil (8) und/oder dem Anschlußteil (9) Mittel zur formschlüssigen Verbindung mit der Halteeinrichtung (19a, 19b) zugeordnet sind.

8. Vorwahleinrichtung (1) nach Anspruch 7, **dadurch gekennzeichnet, daß** die Mittel (19a, 19b) eine Schnappverbindung oder eine Bajonettverbindung umfassen.
